# EUROPEAN PATENT APPLICATION

(11) **EP 4 199 378 A1**
(43) Date of publication of application: **21.06.2023**
(21) Application number: 21215857.0
(22) Date of filing: 20.12.2021
(51) Int. Cl.: H04B 10/50, G02B 6/42, H01S 5/00

(54) **A PHOTONICS DEVICE AND A METHOD FOR SUPPRESSING BACKREFLECTIONS IN A PHOTONICS DEVICE**

(71) Applicant: Imec VZW, 3001 Leuven (BE)
(72) Inventor: JANSEN, Roelof, 3001 Heverlee (BE); DAHLEM, Marcus, 3000 Leuven (BE)
(74) Representative: AWA Sweden AB

(57) **Abstract**

According to an aspect of the present inventive concept there is provided a photonics device comprising an optical guide element and a phase shifting element.

The optical guide element is configured to guide an optical signal.

The phase shifting element is configured to receive a portion of the optical signal tapped from the optical guide element. The phase shifting element is further configured to shift a phase of the portion of the optical signal to form a correction signal.

The photonics device is configured to emit an emitted signal based on an untapped portion of the optical signal.

The photonics device is configured to receive a back-reflection of the emitted signal.

The photonics device is further configured to combine the correction signal with the back-reflection such that the correction signal interferes with the back-reflection for suppressing the back-reflection.

## Description

### Technical field

The present inventive concept relates to a photonics device, and more specifically to a photonics device and a method for suppressing back-reflections in a photonics device.

### Background

Optical systems have found widespread application in modern society. Whether constructed of separate free-space optical components or made by integrated photonics, optical systems are found in a variety of different technical fields, such as telecommunication, quantum computing, and optical measurement systems. In these types of systems, light typically carries information either in the form of a transmitted signal, or in the form of a response signal formed as a response to an optical signal emitted from the optical system.

A common problem in optical systems is the occurrence of back-reflections. Back-reflections may be caused by the optical signal impinging onto a reflective or semi-reflective surface or onto a reflective or semi-reflective element such as an optical component in the system. Back-reflections may have a negative impact on the system performance. For example, in systems where a laser is used as a light source, unwanted back-reflections may be guided back into the laser, with reduction of laser performance as a result. Back-reflections may also interfere with the optical signals in the systems, thereby reducing the quality of the signals, negatively affecting the signal-to-noise ratio and possibly jeopardizing the function of the optical system.

For example, in an optics-based measurement system such as a Light Detection and Ranging (LIDAR) system, a LIDAR signal may be emitted, and as a response light may be emitted or scattered back to the LIDAR system by a target, e.g. a vehicle, a person, a building, or particles in the atmosphere through which the emitted signal propagates. It is common that the same optical elements are used to both emit the signal and collect the response signal reflected from the target. The response signal from the target is typically very weak. Further, significant attenuation may occur in the optical path, so that the emitted signal is significantly higher in power than the received response signal. During operation, back-reflected signals from within the optical system may also fall on the detector. Even if such back-reflected signals may be weak compared to the optical signal from which they originate, they might still be strong compared to the very weak received response signal. Back-reflections may therefore have a significant impact on the systems detectability of the response signal of interest, in that the unwanted back-reflections interfere with the response signal, thereby reducing the signal-to-noise ratio. Moreover, back-reflections may even saturate the detector making detection of the response signal challenging and may even damage the detector.

Thus, there is a need in the art of optical systems for improved solutions with respect to the negative effects caused by back-reflections.

### Summary

An objective of the present inventive concept is to mitigate, alleviate or eliminate one or more of the above-identified deficiencies in the art and disadvantages singly or in any combination. These and other objectives are at least partly met by the invention as defined in the independent claims. Preferred embodiments are set out in the dependent claims.

According to a first aspect, there is provided a photonics device comprising:
an optical guide element configured to guide an optical signal;
a phase shifting element configured to receive a portion of the optical signal tapped from the optical guide element, the phase shifting element being further configured to shift a phase of the portion of the optical signal to form a correction signal;
wherein the photonics device is configured to emit an emitted signal based on an untapped portion of the optical signal;
wherein the photonics device is configured to receive a back-reflection of the emitted signal;
wherein the photonics device is further configured to combine the correction signal with the back-reflection such that the correction signal interferes with the back-reflection for suppressing the back-reflection.

By the term "optical signal" is here meant any signal carried by light. Given only as examples, an optical signal may be in the form of, but is by no means limited to, a continuous light beam, a light beam with varying intensity, and/or a sequence of light pulses. In this context the term "light" should be allowed a wide interpretation, not limited to visible electromagnetic radiation but may also include for example ultra-violet light and infra-red light.

According to an embodiment, the components of the photonics device may be integrated onto a common substrate. More specifically, the optical guide element and the phase shifting element may be integrated onto a common substrate, such that the photonics device forms a photonic integrated circuit (PIC). Alternatively, the components such as the optical guide element and the phase shifting element may be separate, e.g. free-space optical components arranged to form the photonics device.

By the term "optical guide element" is here meant any unit, device and/or element capable of guiding an optical signal in the form of light in a predetermined direction. By way of example, the optical guide element may be in the form of an integrated waveguide, an optical fiber, a mirror, or a prism. It should be construed that the optical guide element may be configured to guide the optical signal by itself, or the optical guide element may be part of a set of elements that together guide the optical signal. Such a set may for example be a set of mirrors, or prisms or a combination thereof.

Tapping off a portion of the optical signal may be achieved for example by the use of a beam-splitter, and/or a directional coupler arranged in a path of the optical signal defined by the optical guide element. Alternatively, in case the optical guide element is a waveguide, the tapping off may be achieved by means of a tapping waveguide arranged adjacent to and alongside the optical guide element, such that a portion of the light in the optical guide element may leak over to the tapping waveguide, e.g. by an evanescent field of the light propagating in the optical guide element leaking into the tapping waveguide.

The tapped off portion of the optical signal is guided to a phase shifting element configured to shift the phase of the portion of the optical signal to form a correction signal. The phase shifted correction signal may subsequently be combined with the back-reflection of the emitted signal, such that the correction signal propagates in the same direction as the back-reflection. The phase shifting element may be configured to shift the phase of the portion of the optical signal such that the correction signal is out of phase with the back-reflection. By the present arrangement, the back-reflection may be efficiently suppressed by interference between the correction signal and the back-reflection.

The phase shifted correction signal may be coupled back to the optical guide element, or to a response signal guide element, or any other suitable guide element for optical signals for combining the correction signal with the back-reflection. Coupling back the correction signal to combine it with the back-reflection may be achieved by means of a "back coupler".

Given as a non-limiting example, back coupling may be achieved for example by the use of a beam-splitter, and/or a directional coupler arranged in a path of the correction signal. Given as another non-limiting example, the back-coupling may be achieved by means of a back-coupling waveguide in which the correction signal propagates, the back-coupling waveguide being arranged adjacent to and alongside the optical guide element to which the correction signal should be coupled back, such that a portion of the light in the back-coupling waveguide may leak over to the optical guide element.

It should be realized that the back-coupling may be tunable or it may be fixed.

It should further be realized that the back-coupling may be of a same type as the tapping, or it may be of a different type.

An advantage of the photonics device is that unwanted back-reflections may be efficiently suppressed or even cancelled out. In the present manner unwanted back-reflections may be suppressed or removed from the signal path of the photonics device, reducing or even eliminating interference between unwanted back-reflections and other signals in the photonics device, thereby improving the performance of the photonics device. By way of example, using the photonics device for suppressing the back-reflections may reduce negative effects of optical components in the system and/or improve the signal-to-noise ratio and thereby the quality of any detection of other optical signals in the system.

The unwanted back-reflections may be suppressed without need of anti-reflection coatings of optical components. Anti-reflection coatings may be difficult to design perfectly and may be difficult to adjust, if back-reflections are present after the photonics device has been manufactured. However, it should be realized that the photonics device of the first aspect may still be combined with use of anti-reflection coatings of optical components.

According to an embodiment, an intensity of the portion of the optical signal tapped from the optical guide element, is lower than an intensity of the untapped portion of the optical signal.

In order to provide good quality of the emitted signal, a high intensity of the emitted signal is advantageous. The emitted signal, on the other hand, is based on the untapped portion of the optical signal. Thus, it is important to not tap off a large amount of the optical signal, since the signal quality may be adversely affected.

Further, the amplitude of the back-reflection to be suppressed by the correction signal is typically smaller than the emitted signal. Hence, there is no need to have a correction signal with an amplitude larger than the amplitude of the emitted signal and thus of the untapped optical signal.

An advantage with this embodiment is that a correction signal may be formed by tapping off a portion of the optical signal, with a major part of the intensity of the optical signal remaining in the untapped portion of the optical signal. In the manner described above, a high intensity in the emitted signal may be maintained while still achieving good suppression of the back-reflection.

According to an embodiment, the intensity of the portion of the optical signal tapped from the optical guide element, is 20% or less than an intensity of the optical signal, and preferably 10% or less than an intensity of the optical signal.

According to an embodiment, the phase shifting element is further configured to tunably shift the phase of the portion of the optical signal to form the correction signal.

By tunably shifting the phase is here meant that a phase shift between the optical signal received by the phase shifting element and the correction signal transmitted by the phase shifting element is not fixed and may thus be adjusted. Consequently, the phase shift may be non-constant for example over time such that the phase shift may be changed from one instant to another. Thus, the amount of phase shift may be tuned. By the present arrangement it may be ensured that the correction signal is out of phase with the back-reflection, even if the phase of the back-reflection should be altered. By way of example, the phase shifting element may be a thermal, a liquid crystal, MEMS-based, or an electro-optic phase shifting element. Thereby, the photonics device may allow for dynamic control of the phase of the correction signal.

The photonics device may further be calibrated in order to optimize the back-reflection suppression. By way of example, the photonics device may comprise an additional power tap that may tap off light from where the correction signal and the back-reflection are combined. The tapped off light may be guided to a detector. By temporarily turning off any other signals of the device, the detector may be used to measure only the back-reflection or alternatively the combined back-reflection and the correction signal. The measurement from the detector may be used to monitor the level of suppression, and may be used to tune the phase shift of the photonics device to optimize suppression and to minimize back-reflection. In a photonics device in which also the amplitude of the correction signal may be tuned, the tuning of the amplitude may also be part of the calibration.

An advantage is that with a tunable phase shifting element, the photonics device may be adapted to changes in phase of the back-reflection in order to maintain suppression of the back-reflection. It is conceivable that a photonics device comprising a tunable phase shifting element may further be configured for dynamic phase tuning to adjust the suppression of the back-reflecting if changes of phase in the back-reflection occurs during operation of the photonics device.

However, even if back-reflections do not alter during operation of the photonics device, tuning of the phase may be advantageously used for calibrating the photonics device after the photonics device has been manufactured. Thus, the photonics device is not static after manufacture, which allows the photonics device to be adjusted even if manufacturing of the photonics device does not provide a desired phase shifting in order to properly suppress the back-reflection.

According to an embodiment, the photonics device is further configured to receive a response signal in response to the emitted signal, and wherein the back-reflection of the emitted signal is superposed on the response signal; and
wherein the photonics device is further configured to combine the correction signal with the response signal and the back-reflection such that the correction signal interferes with the back-reflection for suppressing the back-reflection and improving a signal-to-noise ratio of the response signal.

In other words, according to an embodiment there is provided a photonics device comprising:
an optical guide element configured to guide an optical signal;
a phase shifting element configured to receive a portion of the optical signal tapped from the optical guide element, the phase shifting element being further configured to shift a phase of the portion of the optical signal to form a correction signal;
wherein the photonics device is configured to emit an emitted signal based on an untapped portion of the optical signal;
wherein the photonics device is configured to receive a response signal in response to the emitted signal, and a back-reflection of the emitted signal superposed on the response signal;
wherein the photonics device is further configured to combine the correction signal with the response signal such that the correction signal interferes with the back-reflection for suppressing an amplitude of the back-reflection and improving signal-to-noise ratio of the response signal.

The response signal is received as a response to the emitted signal. By way of example, in a LIDAR system the response signal may be emitted light scattered back to the LIDAR system by a target, as for example a vehicle, a person, a building, or particles in the atmosphere through which the emitted signal propagates. By way of further example, in a telecommunication system the response signal may be a message of information sent, for example by another unit having received the emitted signal, in response to the information carried by the emitted signal.

The tapped off portion of the optical signal is guided to a phase shifting element configured to shift the phase of the portion of the optical signal to form a correction signal. The phase shifted correction signal may subsequently be fed back to be combined with the response signal and the back-reflection of the emitted signal superposed thereon, such that the correction signal propagates in the same direction as the back-reflection. The phase shifting element may be configured to shift the phase of the portion of the optical signal such that the correction signal is out of phase with the back-reflection. By the present arrangement, the back-reflection superposed on the response signal may be efficiently suppressed by interference between the correction signal and the back-reflection such that the response signal constitutes the major part of the remaining signal, thus improving signal-to-noise ratio.

An advantage of the photonics device is that unwanted back-reflections may be efficiently suppressed or even cancelled out. In the present manner unwanted back-reflections may be suppressed or removed from the response signal, allowing detection of the response signal with reduced interference thereby improving the performance of the detection. For example, if the photonics device is used in a system for Light Detection and Ranging (LIDAR), the response signal being the LIDAR signal is typically quite weak. The back-reflections may thus be comparable or even stronger than the response signal of interest, making it challenging to perform detection of the response signal with high quality. However, using the photonics device for suppressing the back-reflections may improve the signal-to-noise ratio and thereby the quality of the detection.

According to an embodiment, the optical guide element is a waveguide.

By the term "waveguide" is here meant any unit, device and/or element within which light may be guided, and within which transmission is restricted to a single direction, thereby providing transmission with low loss. By way of example, light may be reflected on inner walls of the waveguide by total internal reflection or by means of a reflective coating provided on the walls of the waveguide. Given as non-limiting examples, the waveguide may be a transparent dielectric waveguide or an optical fiber.

An advantage with the present embodiment is that waveguide may provide an efficient manner of guiding light. The low losses facilitate maintaining a high intensity signal.

Another advantage is that well established standard optical components and/or equipment may be used. As such, optical guide elements may be provided at a low cost.

Yet another advantage by using waveguides is that it facilitates integration of the optical guide element on a photonics integrated circuit (PIC), together with other optical elements of the photonics device. By the present arrangement, a compact photonics device may be provided. Further, the optical guide element may be pre-aligned with other optical elements of the photonics device, which may simplify operation of the photonics device by a user.

According to an embodiment, the photonics device further comprises a back-reflection suppressing device comprising:
the phase shifting element;
a dynamic power tap device configured to tunably tap off the portion of the optical signal from the optical guide element such that the amplitude of the correction signal is controllable;
wherein the back-reflection suppressing device is configured to guide the portion of the optical signal through the phase shifting element to form the correction signal being phase shifted and amplitude controlled, and to combine the correction signal with the back-reflection such that the correction signal interferes with the back-reflection for suppressing the back-reflection.

With the dynamic power tap device, the amplitude of the portion of the optical signal tapped from the optical guide element may be tuned such that only the amplitude required to match the amplitude of the correction signal with that of the back-reflection with which it is combined, is tapped off. By the present arrangement, only the amplitude of the portion of the optical signal needed for suppression of the back-reflection is tapped off.

An advantage with this embodiment is that a photonics device with small or even minimal losses may be provided. Since only the amplitude of the portion of the optical signal needed for suppression is tapped off, more of the optical signal may remain in the untapped portion of the optical signal, thereby increasing the intensity of the emitted signal. Further, since the correction amount is tapped off from the optical signal, the need for further amplitude control may be eliminated. Thus, attenuation of the correction signal may not be required in order to match the amplitude of the correction signal with that of the back-reflection with which it is combined, in order to achieve good suppression of the back-reflection. Hence, more of the optical signal is used in the photonics device and less light is lost, as compared to photonics devices with attenuation of the correction signal.

According to an embodiment, the photonics device further comprises a back-reflection suppressing device comprising:
the phase shifting element;
an amplitude control element configured to tunably control an amplitude of the correction signal;
wherein the back-reflection suppressing device is configured to receive the portion of the optical signal, to sequentially guide the portion of the optical signal through phase shifting element and the amplitude control element to form the correction signal being phase shifted and amplitude controlled, and to combine the correction signal with the back-reflection such that the correction signal interferes with the back-reflection for suppressing the back-reflection.

The amplitude control element is configured to tunably control the amplitude of the correction signal. The amplitude of the correction signal should be tuned to match the amplitude of the back-reflection, in order to improve suppression of the back-reflection by interference with the correction signal. By way of example, the amplitude control element may attenuate the correction signal such that the amplitude of the correction signal matches the amplitude of the back-reflection. The approach of attenuation is suitable when the portion tapped from the optical signal has a greater amplitude than that of the back-reflection. Given as a non-limiting example, the amplitude control element may be a Mach Zehnder modulator. It is, however, conceivable that the amplitude control element may further amplify the amplitude of the correction signal, in case the amplitude of the correction signal is lower than that of the back-reflection.

It should be understood that if amplitude of the back-reflection is greater than that of the correction signal with which it is combined, a portion of the back-reflection may remain. On the other hand, if the amplitude of the back-reflection is lower than that of the correction signal with which it is combined, a portion of the correction signal may remain. A remaining signal, regardless of whether it is a back-reflection or a correction signal, may have negative effects of the photonics device and/or other devices that may be combined with the photonics device

If the photonics device is further configured for receiving a response signal upon which the back-reflection is superposed, a remaining signal after back-reflection suppression may have a negative effect on the response signal.

An advantage with the present embodiment is that the suppression of the back-reflection may be further improved. By matching the amplitude of the correction signal with that of the back-reflection with which it is combined, the correction signal and the back-reflection may even cancel each other out. In this manner, not only back-reflection suppression but also cancellation may be provided, such that only the response signal remains after signal combination. Further, effective suppression of the back-reflection may be achieved even if changes of the amplitude of the back-reflection occurs during operation of the photonics device.

According to an embodiment, the photonics device may be further configured to combine the correction signal with the back-reflection in the optical guide element.

An advantage of the present embodiment is that the photonics device may allow for two-way communication through the optical guide element. The optical signal may be sent in a first direction of the optical guide element, and the response signal may be sent in a second direction of the optical guide element, wherein the second direction is opposite to the first direction. By the present arrangement, less components are required for the photonics device. In turn, a photonics device with a smaller footprint and at a lower cost may be provided.

According to an embodiment, the back-reflection suppressing device further comprises a second phase shifting element.

The photonics device may be configured such that the back-reflection suppressing device effectively forms a suppression loop from the optical guide element, through the phase shifting element, and back to the optical guide element where the correction signal is combined with the back-reflection. It is conceivable that, in such a photonics device, a counterpropagating reflection of the optical signal may propagate in a direction in the suppression loop opposite of that of the generation of the correction signal. Such a counterpropagating reflection may interfere with the received response signal once the counterpropagating reflection returns to the optical guide element. The second phase shifting element may be used to generate a second phase shifted signal in order to suppress the counterpropagating reflection in the suppression loop.

An advantage with this embodiment is that it may improve signal-to-noise ratio of the response signal, even if counterpropagating reflections occur in the suppression loop.

According to an embodiment, the photonics device may be further configured to combine the correction signal with the response signal in a response signal guide element.

By the term "response signal guide element" is here meant any unit, device and/or element capable of guiding an optical signal in the form of light in a predetermined direction. By way of example, the response signal guide element may be in the form of a waveguide, an optical fiber, a mirror, or a prism. It should be construed that the response signal guide element may be of the same type as the optical guide element or it may alternatively be of a different type.

By the present arrangement, the optical signal and the response signal are guided by separate guide elements.

An advantage with this embodiment is that a photonics device with more flexibility as to where the signals are guided may be provided.

Another advantage is that, by using individual and separated guide elements for the signals, better signal separation and thereby less signal interference may be provided. This arrangement may further improve the signal quality of the response signal and thus the signal-to-noise ratio.

According to an embodiment, the photonics device may further comprise an optical circulator, wherein the optical circulator comprises a first port configured to receive the untapped portion of the optical signal from the optical guide element, wherein the optical circulator comprises a second port configured to emit the emitted signal based on an untapped portion of the optical signal and to receive the response signal and the back-reflection of the emitted signal superposed on the response signal, and wherein the optical circulator comprises a third port configured to emit the response signal and the back-reflection of the emitted signal superposed on the response signal into the response signal guide element.

An advantage with this embodiment is that an efficient and compact manner of directing the signals may be provided.

Another advantage is that optical circulators are well established standard optical components. As such, optical guide elements may be provided at a low cost.

According to a second aspect of the present inventive concept there is provided a method for suppressing back-reflection in a photonics device, the method comprising:
guiding an optical signal;
tapping off a portion of the optical signal;
shifting a phase of the portion of the optical signal to form a correction signal;
emitting an emitted signal based on an untapped portion of the optical signal;
receiving a back-reflection of the emitted signal;
combining the correction signal with the back-reflection such that the correction signal interferes with the back-reflection for reducing the back-reflection.

According to an embodiment, the shifting the phase of the portion of the optical signal further comprises:
tunably shifting the phase of the portion of the optical signal to form the correction signal.

According to an embodiment, the tapping off a portion of the optical signal is configured such that an intensity of the portion of the optical signal tapped from the optical guide element, is lower than an intensity of the untapped portion of the optical signal.

According to an embodiment, the method further comprises:
tunably controlling an amplitude of the correction signal.

Effects and features of the second aspect are largely analogous to those described above in connection with the first aspect. Embodiments mentioned in relation to the first aspect are largely compatible with the second aspect. It is further noted that the inventive concepts relate to all possible combinations of features unless explicitly stated otherwise.

Other objectives, features and advantages of the present inventive concept will appear from the following detailed disclosure, from the attached claims as well as from the drawings.

### Brief descriptions of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.
Fig. 1A illustrates a photonics device for suppression of back-reflections, comprising a phase shifting element.
Fig. 1B illustrates a photonics device further configured to receive a response signal in response to an emitted signal.
Fig. 2A illustrates a photonics device further comprising a back-reflection suppressing device with a dynamic power tap device.
Fig. 2B illustrates a photonics device further comprising a back-reflection suppressing device with an amplitude control element.
Fig. 3 illustrates a photonics device, wherein the back-reflection suppressing device further comprises a second phase shifting element.
Fig. 4 illustrates a photonics device further configured to receive a response signal in response to an emitted signal, and to combine a correction signal with the response signal in a response signal guide element.
Fig. 5 illustrates a schematic block diagram shortly summarizing the method for suppressing back-reflection in a photonics device.

### Detailed description

In cooperation with attached drawings, the technical contents and detailed description of the present inventive concept are described thereinafter according to a preferable embodiment, being not used to limit the claimed scope. This inventive concept may be embodied in many different forms and should not be construed as limited to the embodiments set forth herein; rather, these embodiments are provided for thoroughness and completeness, and fully convey the scope of the inventive concept to the skilled person.

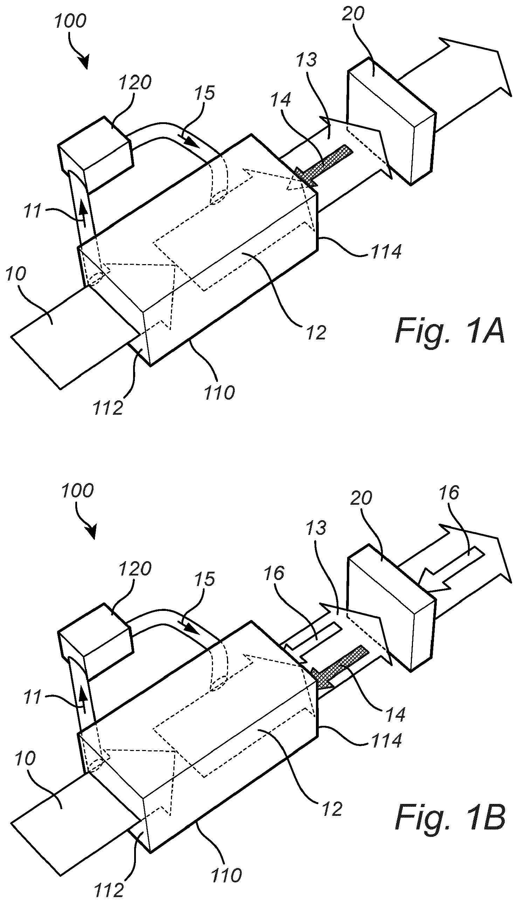

Fig. 1A illustrates a photonics device 100. The photonics device 100 comprises an optical guide element 110. The optical guide element 110 comprises a receiving end 112 and an emitting end 114. The optical guide element 110 is configured to receive an optical signal 10 at the receiving end 112. Further, the optical guide element 110 is configured to guide the optical signal 10 through the optical guide element 110, towards the emitting end 114.

The optical guide element 110 is illustrated as a waveguide, which could be an integrated waveguide of a photonics integrated circuit. However, it should be realized that the optical guide element 110 is not limited to being a waveguide, and may for example be in the form of an optical fiber, in an alternative embodiment.

During the propagation of optical signals 10 through the optical guide element 110, a portion 11 of the optical signal 10 is tapped from the optical guide element 110. An untapped portion 12 of the optical signal 10 continues through the optical guide element 110 to reach the emitting end 114. At the emitting end 114, the optical guide element 110 is configured to emit an emitted signal 13 based on an untapped portion 12 of the optical signal 10. For simplicity the emitted signal 13 may be regarded as being the same as the untapped portion 12. However, it should be realized that losses may occur upon transmission of the untapped portion 12 through the emitting end 114, such that the intensity of the emitted signal 13 is not identical to the intensity of the untapped portion 12. Further, it is conceivable that a small portion of the untapped portion 12 may also be back-reflected at the emitting end 114.

The emitted signal 13 is emitted from the photonics device 100 and may propagate to reach for example reflective elements 20 exterior to the photonics device 100. By way of example, if the photonics device 100 forms part of a larger optical system, such as a telecommunication system or optics-based measurement systems such as a Light Detection and Ranging (LIDAR) system, such reflective elements 20 may be other optical components in the system. In such a case, a back-reflection 14 of the emitted signal may be reflected back towards the photonics device 100.

The back-reflection 14 may be received by the photonics device 100. As illustrated in Fig. 1A, the back-reflection 14 may enter the emitting end 114 of the optical guide element 110, and if this occurs the back-reflection 14 may propagate through the optical guide element 110 in an opposite direction as compared to the propagation direction of the optical signal 10, towards the receiving end 112 of the optical guide element 110.

If the back-reflection 14 exits the optical guide element 110 through the receiving end 112, the back-reflection may enter the part providing the optical signal 10 to the photonics device 100. By way of example, such a part may be a laser or another type of light source. The back-reflection may negatively affect the performance of such a light source, for which reason there is a need for suppressing the back-reflection prior to it reaching the receiving end 112 of the optical guide element 110.

The photonics device 100 further comprises a phase shifting element 120. The photonics device is configured such that the phase shifting element 120 receives the portion 11 of the optical signal 10 tapped from the optical guide element 110. The phase shifting element 120 is configured to shift the phase of the portion 11 of the optical signal 10, to form a correction signal 15.

Phase shifting may be achieved for example by guiding the light through an element made of a material with strong electro-optic effect. By applying an electric field to the element, the optical path length through the element may change, and consequently resulting in change of phase of the light. Given as a non-limiting example, the phase shifting element 120 may be a waveguide across which an electric field may be applied. By varying the electric field, the phase shift may be tunable.

Given as another non-limiting example, the phase shifting element 120 may be thermo-optic phase shifter, where a heater is used to heat the waveguide and the cladding surrounding it. Thermo-optic phase shifters may be made from material chosen so that the refractive index has a thermo-optic coefficient. A phase shift may thus be generated as a result of the applied heat, due to changes in the effective refractive index of the waveguide.

The photonics device 100 is further configured to combine the correction signal 15 with the back-reflection 14. In this manner, the correction signal 15 interferes with the back-reflection 14. The phase shifting element 120 is configured such that the phase of the correction signal 15 is out of phase with the back-reflection 14 where the two signals are combined. By the present arrangement, the back-reflection 14 is suppressed by interference with the correction signal 15. Provided that the correction signal 15 is 180° out of phase with the back-reflection 14, and that the respective amplitudes are the same, the back-reflection 14 may even be essentially cancelled out.

It should be understood that if a small portion of the untapped portion 12 is back-reflected at the emitting end 114, this back-reflection may be considered to form part of the back-reflection 14. Further, also the back-reflection of a small portion of the untapped portion 12 may be suppressed.

As illustrated in Fig. 1A, the correction signal 15 is combined with the back-reflection 14 in the optical guide element 110. The correction signal 15 and the back-reflection 14 may propagate in opposite direction through the optical guide element 110 as compared to the propagation of the optical signal 10. However, it should be realized that the correction signal 15 and the back-reflection 14 may alternatively be combined in a guide element being separate from the optical guide element 110.

The phase shifting element 120 may provide a fixed phase shift with respect to the phase of the incident signal. Alternatively, the phase shifting element 120 may provide a tunable shift with respect to the phase of the incident signal. By means of tunable phase shift, the photonics device 100 may be tuned such that the correction signal is phase shifted essentially 180° with respect to the back-reflection, thereby providing enhanced suppression of the back-reflection.

It should be realized that in the case of the phase shift being fixed, the phase shifting element 120 may alternatively not be a separate element, but may rather be a part of a waveguide in which the correction signal 15 is propagating.

Typically, back-reflections 14 are not as strong as the signal from which the back-reflection 14 originates, i.e. in this case the emitted signal 13. Therefore, the tapped portion 11 of the optical signal 10 used to form the correction signal 15 need not be large in comparison to the optical signal 10. Thus, the intensity of the portion 11 of the optical signal 10 tapped from the optical guide element 110, is lower than an intensity of the untapped portion 12 of the optical signal 10. Given as non-limiting examples, the intensity of the portion 11 of the optical signal 10 tapped from the optical guide element 110, may be 20% or less than the intensity of the optical signal 10, or 10% or less than the intensity of the optical signal 10. In this manner, the majority of the optical signal remains to form the emitted signal 13 thereby maintaining much of the signal strength.

It should be realized that tapping off a portion 11 of the optical signal 10 and providing it to the phase shifting element 120 may be achieved in a number of different manners. For example, it may be achieved by means of an optical fiber, a beam splitter, a grating coupler, and/or a tapping waveguide arranged alongside the optical guide element 110 coupling evanescent light from the optical guide element 110 into the tapping waveguide.

In the figures of the present disclosure, optical signals, back-reflections, etcetera are illustrated as arrows. Although the signals are illustrated as arrows being planar and having different widths, the widths do not correspond to where the signals are located in physical space of the optical guide element, but are rather related to the intensity of the respective signals. Thus, a strong optical signal is illustrated as a wider arrow as compared to a weak signal. It should be understood that, regarding physical location of the respective signals, the signals fill up at least a major part of the height and width of the optical guide element.

As described above, in relation to Fig. 1A, the photonics device 100 may be used to suppress back-reflections in the photonics device 100 when used for emitting an emitted signal 13.

Fig. 1B illustrates an alternative version of the photonics device 100. The optical guide element 110 is configured to guide the optical signal 10, to emit an emitted signal 13 and to provide suppression of back-reflections 14 of the emitted signal 13, by means of tapped off portion 11 of the optical signal 10 being phase shifted by a phase shifting element 120.

Further, the photonics device 100 is configured to receive a response signal 16 in response to the emitted signal 13. By way of example, if the photonics device 100 is used in a telecommunication system, the response signal 16 may be a signal carrying a message that may be a response to a message of the emitted signal 13. By way of further example, if the photonics device 100 is used in an optics-based measurement system such as a Light Detection and Ranging (LIDAR) system, the response signal 16 may be a measurement signal emitted or scattered back to the LIDAR system a target to be detected or by particles in the atmosphere through which the emitted signal propagates. Thus, the response signal 16 may be a signal of interest and therefore a signal to be detected.

The back-reflection 14 of the emitted signal 13 may be superposed on the response signal 16. In such a case, the back-reflection 14 may cause disturbances in the response signal 16. Subsequent detection of the response signal may be compromised such that for example the signal-to-noise ratio of the response signal 16 is low. However, the photonics device 100 is further configured to combine the correction signal 15 with the response signal 16 and the back-reflection 14 such that the correction signal 15 interferes with the back-reflection 14. As described also in relation to Fig. 1A, the phase shifting element 120 is configured such that the phase of the correction signal 15 is out of phase with the back-reflection 14 where the two signals are combined. The back-reflection 14 is thus suppressed by interference with the correction signal 15. By the present arrangement of suppressing the back-reflection 14, improvement of the signal-to-noise ratio of the response signal 16 may be provided.

In the present arrangement of photonics device 100, the response signal is received and guided through the optical guide element 110 in the opposite direction of propagation as compared to the optical signal 10. The response signal 16 may exit the photonics device 100 through the receiving end 112, from where it may be further guided to a detector (not shown).

In relation to Fig. 1A the photonics device 100 has been described in to receive a back-reflection 14 and to suppress the back-reflection 14, without receiving a response signal 16, whereas the photonics device 100 in relation to Fig. 1B is described as also receiving a response signal 16, and to improve the quality of the response signal 16 by suppression of the back-reflection 14. It should be understood that the photonics device 100 may be used for either application.

In relation to the following figures, the photonics device will be described as receiving a response signal, however it should be realized that the photonics device may be equally applicable in a situation where no response signal is received, and where suppression of back-reflection is required.

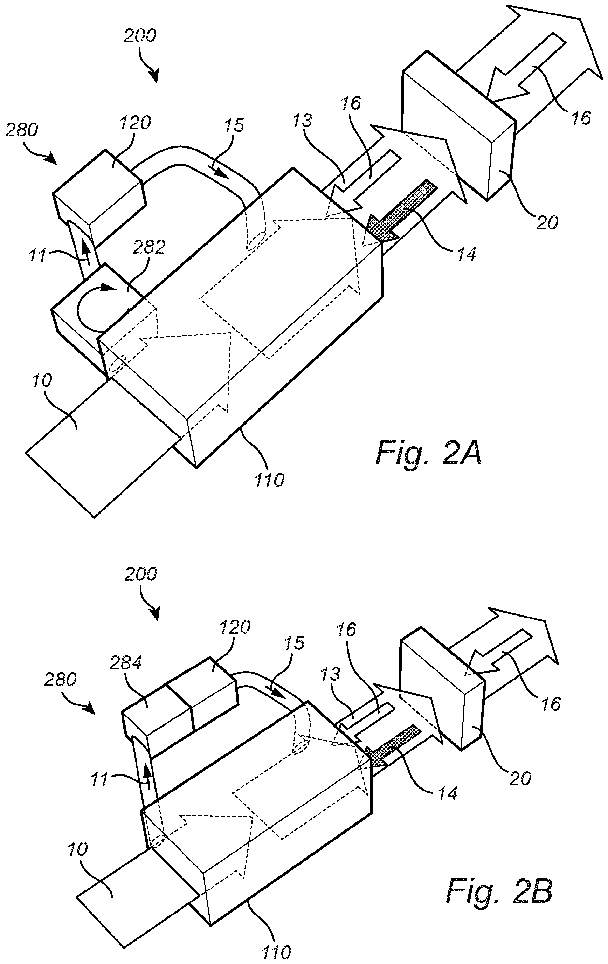

Fig. 2A illustrates a photonics device 200. The photonics device 200 comprises an optical guide element 110 configured to receive an optical signal 10 at the receiving end 112, and to guide the optical signal 10 through the optical guide element 110, towards the emitting end 114.

The photonics device 200 further comprises a back-reflection suppressing device 280. The back-reflection suppressing device 280 comprises a dynamic power tap device 282. The dynamic power tap device 282 is configured to tunably tap off the portion 11 of the optical signal 10 from the optical guide element 110. By the present arrangement, the amplitude of the tapped off portion 11 is controllable.

Given as a non-limiting example, in case the optical guide element 110 is a waveguide, a dynamic power tap 282 may be achieved by means of a tapping waveguide being arranged adjacent to and alongside the optical guide element 110, such that a small gap is formed between the two waveguides. By the present arrangement, a portion of the light in the optical guide element 110 may leak across the gap to be coupled into the tapping waveguide. The amount of light being coupled from the optical guide element 110 to the tapping waveguide may depend on the size of the gap. Thus, by varying the distance between the two waveguides, a variable power tap may be provided.

Given as another non-limiting example, a dynamic power tap 282 may be in the form of a variable ratio fiber-optic coupler.

Given as another non-limiting example, a dynamic power tap 282 may be implemented using a Mach Zehnder modulator with a variable phase in one of the arms.

The untapped portion 12 of the optical signal 10 continues through the optical guide element 110. At the emitting end 114, the optical guide element 110 is configured to emit an emitted signal 13 based on an untapped portion 12 of the optical signal 10. The emitted signal 13 is emitted from the photonics device 200 and may propagate to reach for example reflective elements 20 exterior to the photonics device 100. In such a case, a back-reflection 14 of the emitted signal 13 may be reflected back towards and be received by the photonics device 200.

The back-reflection suppressing device 280 of the photonics device 200 further comprises a phase shifting element 120. The portion 11 of the optical signal 10 tapped from the optical guide element 110 by the dynamic power tap device 282 is guided through the phase shifting element 120. The phase shifting element 120 is configured to shift the phase of the portion 11 of the optical signal 10, to form a correction signal 15.

By means of the dynamic power tap device 280, the amplitude of the correction signal 15 may be adjusted. More specifically, the amplitude of the correction signal 15 may be adjusted such that it matches the amplitude of the back-reflection 14. Further, the phase shifting element 120 is configured such that the phase of the correction signal 15 is out of phase with the back-reflection 14 where the two signals are combined. The back-reflection 14 is thus suppressed by interference with the correction signal 15. Provided that the correction signal 15 is 180° out of phase with the back-reflection 14, and that the respective amplitudes are matched, the back-reflection 14 may even be essentially cancelled out. Consequently, if a response signal 16 is received, upon which the back-reflection 14 is superposed, the back-reflection suppression will improve the quality of the response signal 16 with respect to signal-to-noise ratio.

By means of the dynamic power tap device 282, it may be ensured that only the amount of light needed for back-reflection suppression is tapped off from the optical guide element 110. Furthermore, if the amplitude of the back-reflection 14 varies over time, it may still be suppressed by means of the dynamic power tap device 282. By the present arrangement, tapping off unnecessary light may be avoided. Thus, more of the optical signal 10 may remain in the optical guide element 110 so as to maintain good signal strength of the emitted signal 13.

Fig. 2B illustrates an alternative configuration of the photonics device 200, wherein the back-reflection suppressing device 280 comprises an amplitude control element 284, instead of the dynamic power tap device 282. The amplitude control element 284 is configured to tunably control the amplitude of the tapped off portion 11 of the optical signal 10, and thereby to control the amplitude of the correction signal 15.

Given as a non-limiting example, the amplitude control element 284 may be in the form of a Mach Zehnder modulator. In a Mach Zehnder modulator, the input light wave is split up into two separate waveguide arms. By applying an electric field across one of the arms, the optical path length through the arm may change, thereby resulting in a phase shift for the light passing through that arm. Upon recombination of the light in the two arms, the phase difference between the two light waves results in an amplitude modulation. Thus, by varying the electric field across one of the two waveguide arms, a variable amplitude control element 284 may be provided.

Given as another non-limiting example, the amplitude control element 284 may be an element with a variable light absorption property, e.g. as an effect of a variable electric field applied across the element. By varying the light absorption through the element, the amount of light passing through the element may be varied.

The amplitude control element 284 may attenuate the tapped off portion 11 of the optical signal 10 to match the amplitude with the back-reflection 14. This is provided that the tapped off portion 11 of the optical signal 10 has an amplitude equal to or larger than the amplitude of the back-reflection 14.

In Figs 2A and 2B, the back-reflection suppressing device 280 is illustrated as comprising either a dynamic power tap device 282 or an amplitude control element 284. However, it should be realized that the back-reflection suppressing device 280 may alternatively comprise both a dynamic power tap device 282 and an amplitude control element 284.

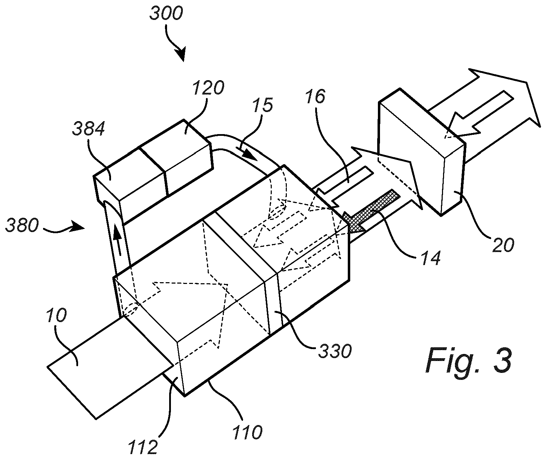

Fig. 3 illustrates a photonics device 300, wherein the back-reflection suppressing device 380 further comprises a second phase shifting element 330. The photonics device 300 may be configured such that the back-reflection suppressing device 380, along with the optical guide element 110, effectively forms a suppression loop. It is conceivable that a counterpropagating reflection of the optical signal 10 may propagate in a direction in the suppression loop opposite of that of the generation of the correction signal 15, in the photonics device 300. Such a counterpropagating reflection may negatively affect the suppression of back-reflections 14, and may further interfere with the received response signal 16 once the counterpropagating reflection returns to the optical guide element 110. The second phase shifting element 330 may be used to generate a second phase shifted signal that may be tapped off from the optical signal 10 in the optical guide element 110, such that the second phase shifted signal propagates in the opposite direction in the suppression loop. By the present arrangement, counterpropagating reflections in the suppression loop may also be suppressed. In this manner, an improved reflection suppression and thus an improved signal-to-noise ratio of the response signal 16 may be provided.

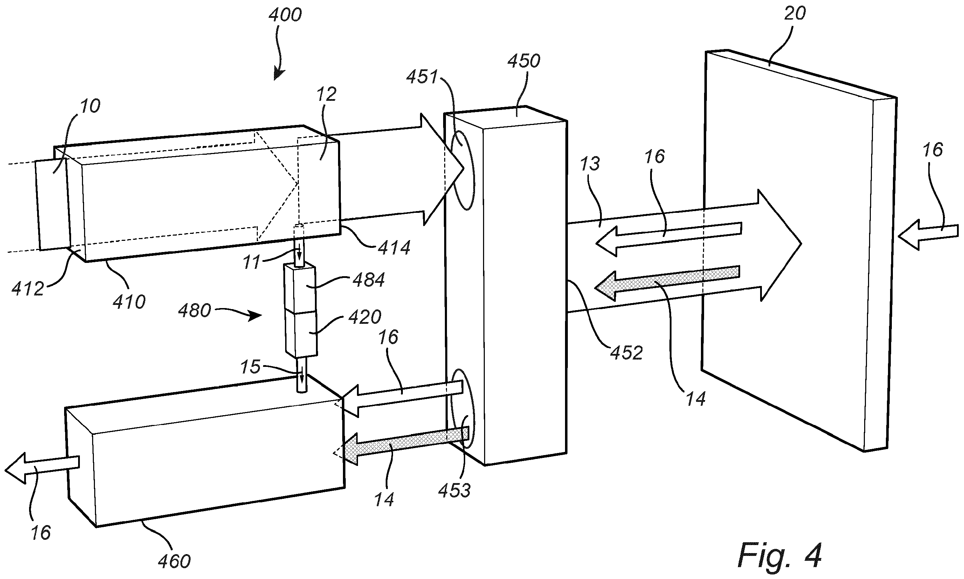

Fig. 4 illustrates a photonics device 400 comprising an optical guide element 410 and a separate response signal guide element 460. The optical guide element 410 is configured to receive an optical signal 10 at the receiving end 412, and to guide the optical signal 10 through the optical guide element 410, towards the emitting end 414.

During the propagation of optical signals 10 through the optical guide element 410, a portion 11 of the optical signal 10 is tapped from the optical guide element 410 to a back-reflection suppressing device 480. An untapped portion 12 of the optical signal 10 continues through the optical guide element 410 to reach the emitting end 414.

From the emitting end 414 of the optical guide element 410 the untapped portion 12 of the optical signal 10 is coupled into a light distribution device 450. The light distribution device 450 may be an optical circulator 450, however, it is conceivable that the light distribution device 450 may alternatively be a different type of optical component.

The optical circulator 450 comprises a first port 451 configured to receive the untapped portion 12 of the optical signal 10 from the optical guide element 410. The optical circulator 450 is configured to guide the untapped portion 12 of the optical signal 10 from the first port 451 to a second port 452 of the optical circulator 450. The second port 452 is configured to emit the emitted signal 13 based on an untapped portion 12 of the optical signal 10.

The photonics device 400 is configured to receive a response signal 16 in response to the emitted signal 13. Further, back-reflections 14 of the emitted signal 13 may be caused by reflective elements 20 in the path of the emitted signal 13. The second port 452 of the optical circulator is thus configured to receive the response signal 16 and the back-reflection 14 of the emitted signal 10 superposed on the response signal 16.

The optical circulator 450 is configured to guide the signals received at the second port 452 to a third port 453 of the optical circulator 450. The third port 453 is configured to emit the response signal 16 and the back-reflection 14 of the emitted signal 10 superposed on the response signal 16 into the response signal guide element 460. Thus, in the photonics device 400, the response signal 16 propagates along a different path than the optical signal 10. The response signal guide element 460 may be configured to guide the response signal 16 towards a detector (not shown), such that the response signal may be detected.

As previously mentioned, a portion 11 of the optical signal 10 is tapped from the optical guide element 410 to a back-reflection suppressing device 480. The back-reflection suppressing device 480 comprises an amplitude control element 484, configured to tunably control the amplitude of the tapped off portion 11 of the optical signal 10. The amplitude control element 484 may attenuate the tapped off portion 11 of the optical signal 10 to match the amplitude with the back-reflection 14.

The back-reflection suppressing device 480 further comprises a phase shifting element 420. After having passed the amplitude control element 484, the tapped off portion 11 of the optical signal 10 is guided through the phase shifting element 420. The phase shifting element 420 is configured to shift the phase of the portion 11 of the optical signal 10, to form a correction signal 15.

The correction signal 15 of the back-reflection suppressing device 480 is coupled into the response signal guide element 460, thereby combining the correction signal 15 with the response signal 16 and the superposed back-reflection 14, in the response signal guide element 460. By the present arrangement, the correction signal 15 interferes with the back-reflection 14, thereby suppressing the back-reflection 14 by interference with the correction signal 15. The back-reflection suppression may be enhanced by the phase shifting element 420 being configured such that the phase of the correction signal 15 is out of phase with the back-reflection 14. The back-reflection suppression may be further enhanced by the amplitude control element 484 allowing adjustment of the amplitude of the correction signal 15 to match the amplitude of the back-reflection. By the present arrangement of suppressing the back-reflection 14, improvement of the signal-to-noise ratio of the response signal 16 may be provided.

In the figures described herein, photonics devices having two ports (Figs 1-3), and three ports (Fig. 4) have been described. However, it should be understood that the inventive concept is not limited to photonics devices having two or three ports for input and output of signals. It is conceivable that a photonics device may alternatively have only one port, or that it may have four, five, six or more ports, for input and output of signals. By way of example, a four-port photonics device may be provided by a 2x2 multimode interferometer comprising two input ports and two output ports.

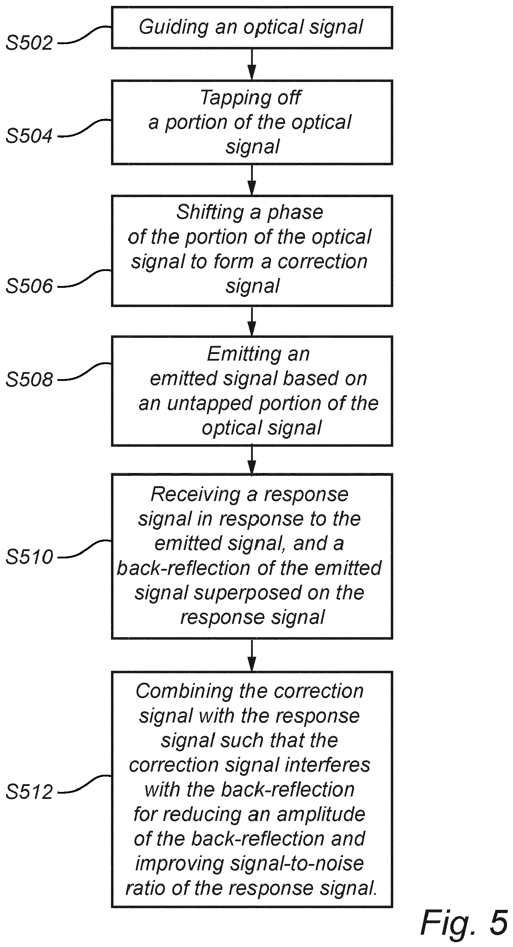

Fig. 5 illustrates a schematic block diagram shortly summarizing the method for suppressing back-reflection in a photonics device. It should be understood that the steps of the method, although listed in a specific order herein, may be performed in any order suitable.

The method may comprise guiding S502 an optical signal.

The method may comprise tapping off S504 a portion of the optical signal. The tapping off S504 a portion of the optical signal may be further configured such that an intensity of the portion of the optical signal tapped from the optical guide element, is lower than an intensity of the untapped portion of the optical signal.

The method may comprise shifting S506 a phase of the portion of the optical signal to form a correction signal. The shifting S506 the phase of the portion of the optical signal may further comprise tunably shifting the phase of the portion of the optical signal to form the correction signal.

The method may comprise emitting S508 an emitted signal based on an untapped portion of the optical signal.

The method may comprise receiving S510 a back-reflection of the emitted signal. The receiving S510 a back-reflection may further comprise receiving a response signal in response to the emitted signal, and wherein the back-reflection of the emitted signal is superposed on the response signal.

The method may comprise combining S512 the correction signal with the back-reflection such that the correction signal interferes with the back-reflection for reducing the back-reflection. The combining S512 may further comprise combining the correction signal with the response signal and the back-reflection such that the correction signal interferes with the back-reflection for suppressing the back-reflection and improving a signal-to-noise ratio of the response signal.

The method may further comprise tunably controlling an amplitude of the correction signal.

In the above the inventive concept has mainly been described with reference to a limited number of examples. However, as is readily appreciated by a person skilled in the art, other examples than the ones disclosed above are equally possible within the scope of the inventive concept, as defined by the appended claims.

For instance, many different variants of phase shifting and amplitude control of the portion of the optical signal are conceivable. As previously described, the amplitude control may be made prior to the phase shifting of the signal, however, applying the phase shift on the portion of the optical signal prior to applying amplitude control is equally conceivable. It is further conceivable that the phase shifting and the amplitude control of the portion of the optical signal may be achieved within the same element and simultaneously.

Further, it should be realized that an optical system may have a number of different back-reflections from different parts of the system. It is therefore conceivable that, either within a photonic device, or within a larger optical system, a plurality of back-reflection suppressing devices are arranged, in order to suppress the different back-reflections in different parts of the system. Alternatively or additionally, it is conceivable that a single back-reflection suppressing device may be controlled so as to optimize suppression to handle a combination of the plurality of back-reflections in the system. In this case, the amplitude of the correction signal does not necessarily need to be equal to the amplitude of any of the back-reflections. Furthermore, in this case, the phase of the correction signal does not necessarily need to be 180° out of phase with respect to any of the back-reflected signals.

## Claims

1. A photonics device comprising:
an optical guide element configured to guide an optical signal;
a phase shifting element configured to receive a portion of the optical signal tapped from the optical guide element, the phase shifting element being further configured to shift a phase of the portion of the optical signal to form a correction signal;
wherein the photonics device is configured to emit an emitted signal based on an untapped portion of the optical signal;
wherein the photonics device is configured to receive a back-reflection of the emitted signal;
wherein the photonics device is further configured to combine the correction signal with the back-reflection such that the correction signal interferes with the back-reflection for suppressing the back-reflection.

2. The photonics device according to claim 1, wherein an intensity of the portion of the optical signal tapped from the optical guide element, is lower than an intensity of the untapped portion of the optical signal.

3. The photonics device according to claim 2, wherein the intensity of the portion of the optical signal tapped from the optical guide element, is 20% or less than an intensity of the optical signal, and preferably 10% or less than an intensity of the optical signal.

4. The photonics device according to any one of the preceding claims, wherein the phase shifting element is further configured to tunably shift the phase of the portion of the optical signal to form the correction signal.

5. The photonics device according to any one of the preceding claims, wherein the photonics device is further configured to receive a response signal in response to the emitted signal, and wherein the back-reflection of the emitted signal is superposed on the response signal; and
wherein the photonics device is further configured to combine the correction signal with the response signal and the back-reflection such that the correction signal interferes with the back-reflection for suppressing the back-reflection and improving a signal-to-noise ratio of the response signal.

6. The photonics device according to any one of the preceding claims, wherein the optical guide element is a waveguide.

7. The photonics device according to any one of the preceding claims, further comprising a back-reflection suppressing device comprising:
the phase shifting element;
a dynamic power tap device configured to tunably tap off the portion of the optical signal from the optical guide element such that the amplitude of the correction signal is controllable;
wherein the back-reflection suppressing device is configured to guide the portion of the optical signal through the phase shifting element to form the correction signal being phase shifted and amplitude controlled, and to combine the correction signal with the back-reflection such that the correction signal interferes with the back-reflection for suppressing the back-reflection.

8. The photonics device according to any one of the preceding claims, further comprising a back-reflection suppressing device comprising:
the phase shifting element;
an amplitude control element configured to tunably control an amplitude of the correction signal;
wherein the back-reflection suppressing device is configured to receive the portion of the optical signal, to sequentially guide the portion of the optical signal through phase shifting element and the amplitude control element to form the correction signal being phase shifted and amplitude controlled, and to combine the correction signal with the back-reflection such that the correction signal interferes with the back-reflection for suppressing the back-reflection.

9. The photonics device according to any one of the preceding claims, further configured to combine the correction signal with the back-reflection in the optical guide element.

10. The photonics device according to claim 9, wherein the back-reflection suppressing device further comprises a second phase shifting element.

11. The photonics device according to any one of claims 1 to 7, further configured to combine the correction signal with the response signal in a response signal guide element.

12. A method for suppressing back-reflection in a photonics device, the method comprising:
guiding an optical signal;
tapping off a portion of the optical signal;
shifting a phase of the portion of the optical signal to form a correction signal;
emitting an emitted signal based on an untapped portion of the optical signal;
receiving a back-reflection of the emitted signal;
combining the correction signal with the back-reflection such that the correction signal interferes with the back-reflection for reducing the back-reflection.

13. The method according to claim 12, wherein the shifting the phase of the portion of the optical signal further comprises:
tunably shifting the phase of the portion of the optical signal to form the correction signal.

14. The method according to any one of claims 12 or 13, wherein the tapping off a portion of the optical signal is configured such that an intensity of the portion of the optical signal tapped from the optical guide element, is lower than an intensity of the untapped portion of the optical signal.

15. The method according to any one of claims 12 to 14, further comprising:
tunably controlling an amplitude of the correction signal.
